# EUROPEAN PATENT SPECIFICATION

(11) **EP 2 206 758 B1**
(45) Date of publication and mention of the grant of the patent: **26.09.2012**
(21) Application number: 10150397.7
(22) Date of filing: 11.01.2010
(51) Int. Cl.: C09J 7/02, C09J 133/08, C08F 220/18, C08F 2/38, C08K 5/37

(54) **Pressure-sensitive adhesive sheet with low emission of sulfur-containing volatile components**
Druckempfindliche Haftklebefolie mit geringer Ausgasung von schwefelhaltigen flüchtigen Verbindungen
Feuille adhésive sensible à la pression à faible dégagement de composés volatils contenant du soufre

(30) Priority: 13.01.2009 JP 2009004464
(43) Date of publication of application: 14.07.2010
(73) Proprietor: Nitto Denko Corporation, Ibaraki-shi, Osaka 567-8680 (JP)
(72) Inventor: Wada, Shouhei, Ibaraki-shi Osaka 567-8680 (JP); Shirai, Mitsuyoshi, Ibaraki-shi Osaka 567-8680 (JP); Takahashi, Akiko, Ibaraki-shi Osaka 567-8680 (JP); Suzuki, Toshihide, Ibaraki-shi Osaka 567-8680 (JP); Yamamoto, Kenichi, Ibaraki-shi Osaka 567-8680 (JP)
(74) Representative: Grünecker, Kinkeldey, Stockmair & Schwanhäusser

(56) References cited:
- EP-A2- 1 325 946
- JP-A- 2004 204 208
- JP-A- 2007 207 800
- US-A1- 2001 027 241

## Description

### 1. Field of the Invention

The present invention relates to a pressure-sensitive adhesive sheet constituted as a two-sided pressure-sensitive adhesive sheet provided with a pressure-sensitive adhesive layer on each side of a substrate, wherein the pressure-sensitive adhesive layer is formed from a water-dispersed pressure-sensitive adhesive composition.

The present application claims priority based on Japanese Patent Application No. 2009-4464 filed on January 13, 2009.

### 2. Description of the Related Art

Compared to a PSA composition of a type where the adhesive constituent is dissolved in an organic solvent, a PSA composition using a water-dispersed acrylic polymer is desirable from the point of view of environmental health since no organic solvent is used as the dispersion medium. Therefore, a PSA sheet using a water-dispersed acrylic PSA composition is being used in a variety of field as a two-sided tape and in other morphologies. As one example of such field of utilization, various electronic equipments such as home appliances and OA equipments may be cited. As a technical reference regarding PSA that uses an acrylic emulsion, Japanese Patent Application Publication No. S61-12775 may be cited.

Depending on the usage mode, a PSA sheet formed from a water-dispersed acrylic PSA composition sometimes causes a metal (for instance, silver) that is not in direct contact with the PSA sheet to corrode. For instance, in a situation where a PSA sheet and a metal material co-exist in a limited space such as inside the housing of an electronic device, corrosion sometimes occurs in the non-contacting metal material described above. Such an event may become a factor provoking a contact defect due to corrosion of a metal constituting the base board or the wiring of the electronic device. In addition, the corrosion of metal described above may create problems in other fields than electronic device, such as a decrease in the quality of external appearance. Thus, a PSA sheet that does not corrode metal is desired.

The present invention was devised to resolve such problems, and its object is to provide a PSA sheet prepared with a water-dispersed acrylic PSA composition, in which the described above non-contact metal corrosion has been suppressed.

Said object is solved by a pressure-sensitive adhesive sheet of claim 1.

The present inventors reasoned that the event in which the PSA sheet causes the non-contact metal to corrode was provoked by a metal-corrosive substance released from the PSA sheet, and focused on sulfur-containing gas (that is to say, a gaseous compound containing sulfur as a constituent atom) as the metal-corrosive substance. In addition, they found out that a sulfur compound widely used as chain transfer agent in the manufacture of acrylic polymer emulsion for PSA (sulfur-containing chain transfer agent, typically n-lauryl mercaptan) may be a major source of the sulfur-containing gas described above. Then, they discovered that even if a sulfur-containing chain transfer agent is used, the problem of metal corrosion described above may be solved by greatly decreasing the emission of the sulfur-containing gas described above to complete the present invention.

The present invention provides a PSA sheet comprising a PSA layer formed from a water-dispersed PSA composition. The PSA composition described above contains a water-dispersed acrylic polymer synthesized in the presence of a chain transfer agent containing sulfur as a constituent atom (sulfur-containing chain transfer agent). Then, in a gas generation test whereby the PSA sheet is heated at 85°C for one hour, the emission of gas containing sulfur as a constituent atom (sulfur-containing gas) per 1 cm² surface area of the sheet is 0.043µg or less when converted to SO₄²⁻(hereinafter, this may be represented as "0.043µg SO₄²⁻/cm² or less"). According to such PSA sheet, owing to the fact that generation of sulfur-containing gas (in particular, gas that may react with a metal such as silver to form a metal sulfide, sulfite, or sulfate; for instance, H₂S, SO₂) is suppressed, the corrosion of metal (for instance, formation of the sulfide, sulfite, or sulfate salt) can be prevented or suppressed efficiently. In addition, since the use of sulfur-containing chain transfer agent is allowed in the synthesis of the water-dispersed acrylic polymer, adjusting the polymer to a suitable molecular weight is facilitated. According to the PSA composition containing an acrylic polymer with a suitably adjusted molecular weight, a more effective PSA sheet may be formed. Consequently, the present invention provides a PSA sheet having excellent metal corrosion prevention properties and great adhesive properties.

In one preferred mode of the technique disclosed herein, the sulfur-containing chain transfer agent is a chain transfer agent that does not essentially generate the sulfur-containing gas described previously, in the gas generation test. According to the PSA sheet of such mode, a higher level in metal corrosion prevention properties may be realized.

As the sulfur-containing chain transfer agents, those having as a main (primary) component (that is to say, a constituent occupying 50% by mass or greater in the sulfur-containing chain transfer agent) a mercaptan having one or fewer hydrogen atoms bonded to the carbon atom to which the mercapto group is bonded (including mercaptans with no hydrogen atom bonded to the carbon atom), or a mercaptan in which the carbon atom has a resonance structure, may be used preferably. Preferred examples of such mercaptans include tertiary mercaptans and aromatic mercaptans.

As a subject of application of the art disclosed herein, two-sided PSA sheet (PSA sheet that is adhesive on both sides) provided with the PSA layer described previously on each side of a substrate may be given as an example. With a PSA sheet having such a constitution, the importance of adjusting the molecular weight of the acrylic polymer is particularly pronounced. Consequently, the ability to use a sulfur-containing chain transfer agent during the synthesis of the water-dispersed acrylic polymer is of particular significance.

Since, as described above, the PSA sheet provided by the art disclosed herein has an extremely low emission of metal-corroding gas, it is suitable as a PSA sheet used inside an electronic device. For instance, it may be used preferably as a PSA sheet used for joining parts in an internal space where metal materials such as circuit base board and wiring co-exist. Consequently, in another aspect, the present invention provides an electronic device having within, a joining site mediated by the PSA sheet described above.

The contents disclosed herein include the following:
(I) A two-sided PSA sheet provided with a PSA layer formed from a water-dispersed PSA composition on each side of a substrate,
   the PSA composition containing an acrylic polymer synthesized using at least one species of mercaptan selected from the group consisting of tertiary mercaptans and aromatic mercaptans, and
   the emission of sulfur-containing gas being 0.043µg SO4²⁻/cm² or less in a gas generation test whereby the PSA sheet is heated at 85°C for one hour.
(2) A water-dispersed PSA composition containing an acrylic polymer synthesized in the presence of a sulfur-containing chain transfer agent,
   the emission of sulfur-containing gas per 1g of the PSA converted into SO₄²⁻ being 2.7µg or less (hereinafter, may be represented as "2.7µg SO₄²⁻/g or less") in a gas generation test whereby a PSA obtained by drying or solidifying the composition is heated at 85°C for one hour. Preferred embodiments of the present invention are set forth in the dependent claims.

### BRIEF DESCRIPTION OF THE DRAWINGS

Fig. 1 is a cross-sectional view showing schematically one constitution example of the PSA sheet according to the present invention;
Fig. 2 is a cross-sectional view showing schematically another constitution example of the PSA sheet according to the present invention;
Fig. 3 is a cross-sectional view showing schematically another constitution example of a PSA sheet which does not fall within the scope of the present invention;
Fig. 4 is a cross-sectional view showing schematically another constitution example of a PSA sheet which does not fall within the scope of the present invention;
Fig. 5 is a cross-sectional view showing schematically another constitution example of a PSA sheet which does not fall within the scope of the present invention; and example of a PSA sheet which does not fall within the scope of the present invention; and
Fig. 6 is a cross-sectional view showing schematically another constitution example of a PSA sheet which does not fall within the scope of the present invention.

### DETAILED DESCRIPTION OF THE INVENTION

In the following, preferred embodiments of the present invention will be described. to-The present invention can be carried out based on the contents disclosed herein and the technical knowledge in the relevant field. In addition, in the following description, like reference numerals are assigned to members or sites producing like effects, and duplicated descriptions are sometimes omitted or simplified.

The PSA sheet of the present invention comprises on each side of a substrate (support) a PSA layer formed from a water-dispersed PSA composition disclosed herein. The concept of PSA sheet herein includes those referred to as adhesive tape, adhesive label, adhesive film and the like. Note that, although the PSA layer described above is typically formed continuously, it is not limited to such a morphology, and the PSA layer may be formed in a regular or random pattern of, for instance, dots, stripes or the like. In addition, the PSA sheet provided by the present invention may be in roll form or in sheet form. Alternatively, the PSA sheet may be of morphologies that have been further processed into a variety of shapes.

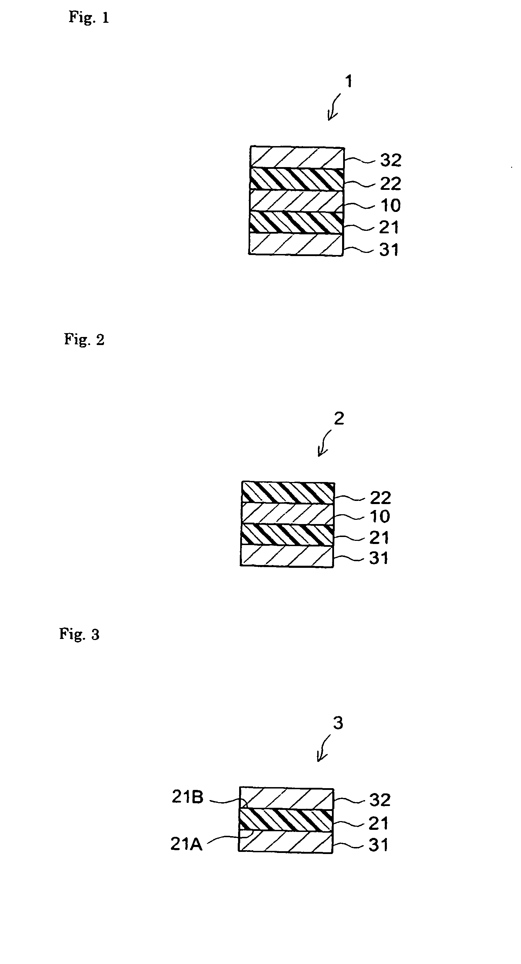

The PSA sheet disclosed herein may have cross-sectional structures, for instance, shown schematically in Fig. 1 and Fig. 2 Fig. 1 and Fig. 2 are constitution examples of substrated PSA sheets of the double-sided adhesive type. The PSA sheet 1 shown in Fig. 1 has a constitution in which PSA layers 21 and 22 are provided on each side of a substrate 10 (both non-releasing) and these PSA layers are respectively protected by release liners 31 and 32, of which at least the PSA layer side is a release side. The PSA sheet 2 shown in Fig. 2 has a constitution in which PSA layers 21 and 22 are provided on each side of a substrate 10 (both non-releasing), the PSA layer 21, which is the first among these, is protected by a release liner 31, of which each side is a release side. This type of PSA sheet 2 can have a constitution in which the PSA layer 22 is also protected by the release liner 31, by rolling the PSA sheet and bringing the second PSA layer 22 in contact with the back side of the release liner 31.

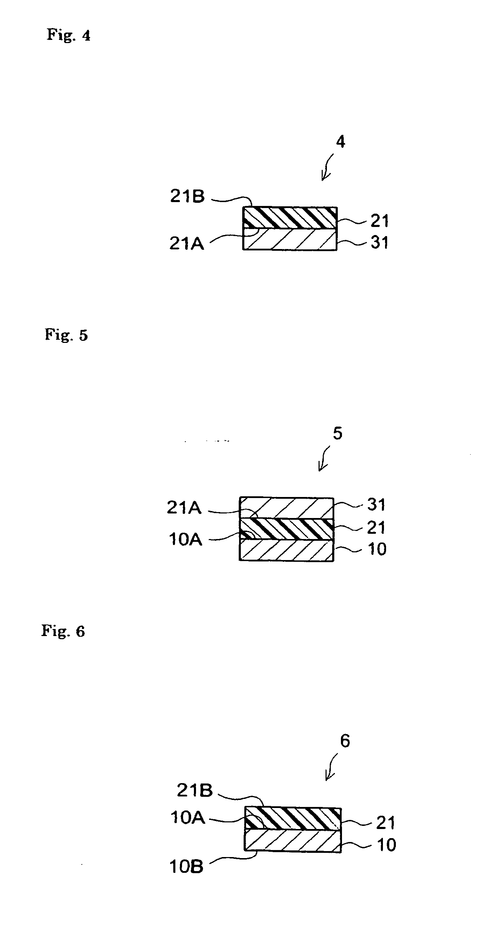

Fig. 3 and Fig. 4 are constitution examples of a substrate-less two-sided PSA sheet and do not fall within the scope of the present inventing. The PSA sheet 3 shown in Fig. 3 has a constitution in which both sides 21A and 21 B of a substrate-less PSA layer 21 are protected respectively by release liners 31 and 32, of which at least the PSA layer side is a release side. The PSA sheet 4 shown in Fig. 4 has a constitution in which a first side 21A of the substrate-less PSA layer 21 is protected by a release liner 31, of which each side is a release side, and when this is rolled, the second side 21B of the PSA layer 21 comes in contact with the back side of the release liner 31, allowing for a constitution in which the second side 21B is also protected with the release liner 31.

Fig. 5 and Fig. 6 are constitution examples of a substrated PSA sheet of the single-sided PSA type and do not fall within the scope of the present inventing. The PSA sheet 5 shown in Fig. 5 has a constitution in which a PSA layer 21 is provided on a first side 10A (non-releasing) of a substrate 10, a surface (PSA side) 21A of this PSA layer 21 is protected with a release liner 31 of which at least the PSA layer side is a release side. The PSA sheet 6 shown in Fig. 6 has a constitution in which a PSA layer 21 is provided on a first side 10A (non-releasing) of a substrate 10. The second side 10B of the substrate 10 is a release side, and when the PSA sheet 6 is rolled, the PSA layer 21 comes into contact with the second side 10B, protecting the surface (PSA side) 21 B of the PSA layer with the second side 10B.

The water-dispersed PSA composition used for forming the PSA layer contains a water-dispersed acrylic polymer This water-dispersed acrylic polymer is an acrylic polymer composition in emulsion form in which an acrylic polymer is dispersed in water. In the technology disclosed herein, the acrylic polymer is used as base polymer of PSA (basic component of PSA) to constitute the PSA layer. For instance, it is desirable that 50% by mass or greater of the PSA is acrylic polymer. As such acrylic polymer, one having alkyl (meth)acrylate as the main constituent monomer (main monomeric constituent, that is to say, a constituent occupying 50% by mass or greater of the total amount of monomers constituting the acrylic polymer) may be used preferably.

Note that herein, "(meth)acrylate" is meant to indicate acrylate and methacrylate comprehensively. Similarly, meant to indicate comprehensively are, respectively, "(meth)acryloyl" for acryloyl and methacryloyl, and "(meth)acrylic" for acrylic and methacrylic.

As alkyl (meth)acrylates, for instance, compounds represented by the following formula (1) can be used suitably:

CH₂ = C(R¹) COOR² (1)

Here, R¹ in the formula (1) represents a hydrogen atom or a methyl group. In addition, R² represents an alkyl group having 1 to 20 carbon atoms. Examples of R² include alkyl groups such as methyl group, ethyl group, propyl group, isopropyl group, butyl group, isobutyl group, s-butyl group, t-butyl group, pentyl group, isoamyl group, neopentyl group, hexyl group, heptyl group, octyl group, isooctyl group, 2-ethylhexyl group, nonyl group, isononyl group, decyl group, isodecyl group, undecyl group, dodecyl group, tridecyl group, tetradecyl group, pentadecyl group, hexadecyl group, heptadecyl group, octadecyl group, nonadecyl group and eicosyl group and the like. Among these, from the point of view of the storage elastic modulus, or the like, of the PSA, an alkyl (meth)acrylate in which R² is an alkyl group having 2 to 14 carbon atoms (hereafter, such a range of number of carbon atoms may sometimes be represented as "C₂₋₁₄") is desirable and an alkyl (meth)acrylate in which R² is a C₂₋₁₀ alkyl group is more desirable. In particular, as preferred R², butyl group and 2-ethylhexyl group are given as examples.

In one preferred mode, of the total amount of alkyl (meth)acrylate used in the synthesis of the acrylic polymer, on the order of 50% by mass or greater (more preferably 70% by mass or greater, for instance on the order of 90% by mass or greater) is an alkyl (meth)acrylate in which R² in the above formula (1) is C₂₋₁₄ (preferably C₂₋₁₀, and more preferably C₄₋₈). According to such a monomer composition, obtaining an acrylic polymer for which the store elastic modulus at close to ordinary temperature is in a suitable range for a PSA is facilitated. Essentially all of the alkyl (meth)acrylate may be C₂₋₁₄ alkyl (meth)acrylate.

The alkyl (meth)acrylate constituting the acrylic polymer in the art disclosed herein may be butylacrylate (BA) alone, may be 2-ethylhexylacrylate (2EHA) alone, or may be both species of BA and 2EHA. When BA and 2ERA are used in combination as alkyl (meth)acrylate, there is no particular limitation on their ratio.

As monomers constituting the acrylic polymer, other monomers that are co-polymerizable with alkyl (meth)acrylate (sometimes may be referred to as "co-polymerizing monomer constituent") may be used in such a range that alkyl (meth)acrylate is the main constituent. The proportion of alkyl (meth)acrytate with respect to the total amount of monomers constituting the acrylic polymer may be on the order of 80% by mass or greater (typically 80 to 99.8% by mass) and preferably 85% by mass or greater (for instance 85 to 99.5% by mass). The proportion of alkyl (meth)acrylate may be 90% by mass or greater (90 to 99% by mass).

These co-polymerizing monomers may be useful for introducing a crosslinking site into the acrylic polymer or for increasing the cohesive strength of the acrylic polymer. Such co-polymerizing monomer can be used alone or by combining two species or more.

More particularly, as co-polymerizing monomers for introducing a crosslinking site into the acrylic polymer, various functional group-containing monomers (typically, a heat-crosslinking functional group-containing monomer for introducing a crosslinking site that crosslinks by heat into the acrylic polymer) can be used. By using such a functional group-containing monomer, the adhesive strength to the adherend may be increased. Such a functional group-containing monomer suffices to be a monomer that is co-polymerizable with alkyl (meth)acrylate and may provide a functional group that is a crosslinking site, and is not limited in particular. For instance, functional group-containing monomers such as the following can be used, alone or by combining two species or more.

Carboxyl group-containing monomers: for instance, ethylenic unsaturated monocarboxylic acids such as acrylic acid, methacrylic acid and crotonic acid; ethylenic unsaturated dicarboxylic acids such as maleic acid, itaconic acid and citraconic acid, and anhydrides thereof (such as anhydrous maleic acid and anhydrous itaconic acid).
Hydroxyl group-containing monomers: for instance, hydroxyalkyl (meth)acrylates such as 2-hydroxyethyl (meth)acrylate, 2-hydroxypropyl (meth)acrylate, 3-hydroxypropyl (meth)acrylate and 2-hydroxybutyl (meth)acrylate; and unsaturated alcohols such as vinyl alcohol and allyl alcohol.

Amide group-containing monomers: for instance, (meth)acrylamide, *N,N-*dimethyl (meth)acrylamide, *N*-butyl (meth)acrylamide, *N*-methylol (meth)acrylamide, N-methylol propane (meth)acrylamide, *N*-methoxy methyl (meth)acrylamide and *N-*butoxy methyl (meth)acrylamide.
Amino group-containing monomer: for instance, aminoethyl (meth)acrylate, *N,N*-dimethylaminoethyl (meth)acrylate and t-butylaminoethyl (meth)acrylate.

Monomers having an epoxy group: for instance, glycidyl (meth)acrylate, methylglycidyl (meth)acrylate and allyl glycidyl ether.
Cyano group-containing monomers: for instance, acrylonitrile and methacrylonitrile.
Keto group-containing monomers: for instance, diacetone (meth)acrylamide, diacetone (meth)acrylate, methyl vinyl ketone, ethyl vinyl ketone, allyl acetoacetate and vinyl acetoacetate.

Monomers having a nitrogen atom-containing ring: for instance, *N*-vinyl-2-pyrrolidone, *N*-methylvinyl-2-pyrrolidone, *N*-vinylpyridinium salt, *N*-vinylpiperidone, *N*-vinylpyrimidine, *N*-vinylpiperazine, *N*-vinylpyrazine, *N*-vinylpyrrole, *N-*vinylimidazole, *N*-vinyloxazole, *N*-vinylmorpholine, *N*-vinylcaprolactam and *N-*(meth)acryloylmorpholine.

Alkoxy silyl group-containing monomers: for instance, 3-(meth)acryloxypropyl trimethoxy silane, 3-(meth)acryloxypropyl triethoxy silane, 3-acryloxypropyl triethoxy silane, 3-(meth)acryloxypropyl methyldimethoxy silane and 3-(meth)acryloxypropyl methyldiethoxy silane.

Among these functional group-containing monomers, one, two or more species selected from carboxyl group-containing monomers or acid anhydrides thereof can be used preferably. Essentially all of the functional group-containing monomer constituent may be a carboxyl group-containing monomer. Among these, as preferred carboxyl group-containing monomers, acrylic acid and methacrylic acid may be given as examples. One of these may be used alone or the acrylic acid and the methacrylic acid may be combined in any proportion and used.

The functional group-containing monomer constituent described above is preferably used in ranges of, for instance, on the order of 12 parts in mass or less (for instance, on the order of 0.5 to 12 parts in mass and preferably on the order of 1 to 8 parts in mass) with respect to 100 parts in mass of alkyl (meth)acrylate. If the amount of functional group-containing monomer constituent is too high, the cohesive strength becomes too high, which may tend to decrease the adhesive properties (for instance adhesive strength).

In addition, in order to increase the cohesive strength of the acrylic polymer, aside from the functional group-containing monomers described above, other co-polymer constituents can be used. As such co-polymer constituents, for instance, vinyl esters such as vinyl acetate and vinyl propionate; aromatic vinyl compounds such as styrene, substituted styrene (such as α-methyl styrene) and vinyl toluene; non-aromatic ring-containing (meth)acrylates such as cycloalkyl (meth)acrylate [such as cyclohexyl (meth)acrylate and cyclopentyl di(meth)acrylate] and isobornyl (meth)acrylate; aromatic ring-containing (meth)acrylates such as aryl (meth)acrylate [for instance phenyl (meth)acrylate], aryloxy alkyl (meth)acrylate [for instance phenoxy ethyl (meth)acrylate] and arylalkyl (meth)acrylate [for instance benzyl (meth)acrylate]; olefins such as ethylene, propylene, isoprene, butadiene and isobutylene; chlorine-containing monomers such as polyvinyl chloride and vinylidene chloride; isocyanate group-containing monomers such as 2-(meth)acryloyloxyethyl isocyanate; alkoxy group-containing monomers such as methoxyethyl (meth)acrylate and ethoxyethyl (meth)acrylate; vinyl ethers such as methyl vinyl ether and ethyl vinyl ether; and the like, may be cited.

As other examples of co-polymerizing monomers, monomers having a plurality of functional groups within a single molecule may be cited. Examples of such multifunctional monomer include 1,6-hexanediol di(meth)acrylate, ethyleneglycol di(meth)acrylate, diethyleneglycol di(meth)acrylate, triethyleneglycol di(meth)acrylate, tetraethyleneglycol di(meth)acrylate, (poly)ethyleneglycol di(meth)acrylate, propyleneglycol di(meth)acrylate, (poly)propyleneglycol di(meth)acrylate, neopentylglycol di(meth)acrylate, pentaerythritol di(meth)acrylate, trimethylol propane tri(meth)acrylate, pentaerythritol tri(meth)acrylate, dipentaerythritol hexa(meth)acrylate, glycerin di(meth)acrylate, epoxy acrylate, polyester acrylate, urethane acrylate, divinyl benzene, butyl di(meth)acrylate, hexyl di(meth)acrylate, and the like.

As methods for obtaining water-dispersed acrylic polymers by polymerizing such monomers, polymerization methods that are well known and in common use can be adopted, and preferably emulsion polymerization can be used. As methods for supplying monomers when carrying out emulsion polymerization, batch feeding method whereby the entirety of the monomers is supplied in a single batch, continuous supply (instillation) method, fractional provision (instillation) method, and the like, can be adopted suitably. A portion or the entirety of the monomers (typically, the entirety) is mixed and emulsified beforehand with water (typically, a suitable amount of emulsifier is used along with water), and the emulsion thereof (monomer emulsion) may be supplied into the reaction vessel in a single batch, gradually or fractionally. The polymerization temperature can be selected suitably according to the species of the monomer, the species of the polymerization initiator, and the like, to be used, and can be, for instance, on the order of 20°C to 100°C (typically 40°C to 80°C).

As polymerization initiators used during polymerization, it can be selected suitably according to the type of polymerization method from among polymerization initiators that are well known and in common use. For instance, in emulsion polymerization methods, azo series polymerization initiators may be used preferably. Examples of azo initiators include 2,2'-azobisisobutylonitrile, 2,2'-azobis(2-methylpropionamidine) disulfate, 2,2'-azobis(2-amidino propane) dihydrochloride, 2,2'-azobis[2-(5-methyl-2-imidazoline-2-yl)propane] dihydrochloride, 2,2'-azobis(*N,N*'-dimethyleneisobutylamidine), 2,2'-azobis[*N*-(2-carboxyethyl)-2-methylpropionamidine] hydrate, 2,2'-azobis(4-methoxy-2,4-dimethylvaleronitrile), 2,2'-azobis(2,4-dimethylvaleronitrile), 2,2'-azobis(2-methylbutylonitrile), 1,1'-azobis(cyclohexane-1-carbonitrile), 2,2'-azobis(2,4,4-trimethylpentane), dimethyl-2,2'-azobis(2-methylpropionate), and the like.

As other examples of polymerization initiator, persulfates such as potassium persulfate and ammonium persulfate; peroxide initiators such as benzoyl peroxide, t-butyl hydroperoxide, di-t-butyl peroxide, t-butylperoxy benzoate, dicumyl peroxide, 1,1-bis(t-butylperoxy)-3,3,5-trimethyl cyclohexane, 1,1-bis(t-butylperoxy)cyclododecane and hydrogen peroxide; substituted ethane initiators such as phenyl-substituted ethane; aromatic carbonyl compounds; and the like, may be cited. As further other examples of polymerization initiators, redox initiators by combination of a peroxide and a reducing agent may be cited. Examples of such redox initiators include combination of a peroxide and ascorbic acid (such as combination of hydrogen peroxide water and ascorbic acid), combination of a peroxide and iron(II) salt (such as combination of hydrogen peroxide water and iron(II) salt), combination of a persulfate and sodium hydrogen sulfite, and the like.

Such polymerization initiators can be used alone or in a combination of two species or more. The amount of polymerization initiator used suffices to be an amount used conventionally, and can be selected from a range of, for instance, on the order of 0.005 to I parts in mass (typically 0.01 to 1 parts in mass) with respect to 100 parts in mass of all monomers combined.

In a typical mode of the art disclosed herein, during the emulsion polymerization described above, a chain transfer agent (may also be understood as a molecular weight adjuster or a polymerization degree adjuster) comprising a compound containing sulfur as a constituent atom is used. The type and amount used of such a sulfur-containing chain transfer agent can be set by taking into account the target properties of the PSA sheet, other materials constituting the PSA sheet, and the like, so that the sulfur-containing gas emission described above is 0.043µg SO₄²⁻/cm² or lower (preferably 0.03µg SO₄²⁻/cm² or lower). The sulfur-containing gas emission described above is determined by determining by converting into SO₄²⁻ mass the mass of sulfur-containing gas (may be H₂S, SO₂ and the like) emitted from the PSA sheet in a gas generation test whereby a PSA sheet is heated at 85°C for one hour, and dividing this mass by the surface area of the PSA sheet. More concretely, determination can be, for instance, by the method for measuring sulfur-containing gas emission described in the examples below. In one preferred mode, regardless of the use of a sulfur-containing chain transfer agent, the sulfur-containing gas emission of the PSA sheet is essentially zero (for instance, as described below, below the detection limit, typically below 0.02µg SO₄²⁻/cm², in a sulfur-containing gas emission measurement with a PSA sheet of on the order of 0.1 g as the measurement sample).

Note that, in order to exert the desired adhesive properties, it is desirable that the amount of sulfur-containing chain transfer agent used is on the order of 0.001 parts in mass or greater (typically on the order of 0.001 to 5 parts in mass) with respect to 100 parts in mass of all monomers. In general, a suitable result may be realized by using on the order of 0.005 to 2 parts in mass (typically on the order of 0.01 to 1 parts in mass) of sulfur-containing chain transfer agent with respect to 100 parts in mass of all monomers. For instance, in the synthesis of a water-dispersed acrylic polymer for a two-sided PSA sheet, an amount used in the range described above may be used preferably.

In the art disclosed herein, a compound having a structural moiety represented by C-SH, that is to say, a mercaptan, can be used as sulfur-containing chain transfer agent. In order to realize a PSA sheet that satisfies the sulfur-containing gas emission range, it is preferable that the sulfur-containing chain transfer agent be of, as its main ingredient, one, two or more mercaptans selected from mercaptans in which only one hydrogen atom (H) is bonded to the carbon atom (C) to which a mercapto group (-SH) is bonded (for instance, mercaptans in which a mercapto group is bonded to a secondary carbon atom, that is to say secondary mercaptans), mercaptans in which no hydrogen atom is bonded to the SH-bearing carbon atom (for instance, mercaptans in which a mercapto group is bonded to a tertiary carbon atom), and mercaptans in which the carbon atom described above has a resonance structure (aromatic mercaptans or the like). It is unlikely for mercaptans with such structures to become a sulfur-containing gas generation source in an acrylic polymer synthesized using the mercaptan. Consequently, according to a water-dispersed PSA composition containing such an acrylic polymer, a PSA sheet may be formed to have adequate adhesive properties, yet no metal corrosivity. Hereafter, mercaptan having such structure as described above may be referred to as "non-corrosive mercaptan". Such a non-corrosive mercaptan may have a structure in which the mercapto group-bearing carbon atom may be bonded to any atom other than a hydrogen atom. For instance, a mercaptan having a structure in which the mercapto group bearing carbon atom is bonded to other 2 or 3 carbon atoms can be used preferably.

As one preferred example of non-corrosion mercaptan, mercaptans having a structure in which a mercapto group is bonded to a tertiary carbon atom (for instance, tertiary alkyl group), that is to say, tertiary mercaptans may be cited. Examples of tertiary mercaptans, tertiary butyl mercaptan, tertiary octyl mercaptan, tertiary nonyl mercaptan, tertiary lauryl mercaptan, tertiary tetradecyl mercaptan, tertiary hexadecyl mercaptan and the like, may be cited. Tertiary alkyl mercaptans having four carbon atoms or more can be used preferably. From the point of view of reducing the odors from PSA compositions and PSA sheets, it is advantageous to select tertiary alkyl mercaptans having six carbon atoms or more (more preferably 8 or more). Although the upper limit of the number of carbon atoms is not particularly set, it is typically 20 or less. For instance, tertiary lauryl mercaptan may be used preferably.

As another preferred example of non-corrosive mercaptan, mercaptans having a structure in which a mercapto group is bonded to a carbon atom constituting an aromatic ring or a heteroaromatic ring, that is to say, aromatic mercaptans, may be cited. For instance, aromatic mercaptans having on the order of 6 to 20 carbon atoms, or heteroaromatic mercaptans having on the order of 2 to 20 carbon atoms and containing a heteroatom, can be used preferably.

The aromatic mercaptans may be compounds having in at least one portion of the structure a bond between a structural moiety having aromaticity (typically, an aromatic ring) and a mercapto group, isomers thereof, or derivatives having a mercapto group. Examples of aromatic mercaptan include phenyl mercaptan, 4-tolyl mercaptan, 4-methoxyphenyl mercaptan, 4-fluorobenzene thiol, 2,4-dimethyl benzene thiol, 4-aminobenzene thiol, 4-fluorobenzene thiol, 4-chlorobenzene thiol, 4-bromobenzene thiol, 4-iodobenzene thiol, 4-t-butylphenyl mercaptan, 1-naphthyl mercaptan, 1-azulene thiol, 1-anthracene thiol, 4,4' thiobenzene thiol, and the like.

The heteroaromatic mercaptans may be compounds having in at least one portion of the structure a bond between an aromatic ring containing a heteroatom (heteroaromatic ring) and a mercapto group, isomers thereof, or derivatives having a mercapto group. Examples of heteroaromatic mercaptan include 2-pyridyl mercaptan, 2-pyrrolyl mercaptan, 2-indolyl mercaptan, 2-furanyl mercaptan, 2-thiophene thiol, 2-benzothiophene thiol, 2-mercapto pyrimidine, and the like.

In one preferred mode of the art disclosed herein, the amount of non-corrosive mercaptan among the sulfur-containing chain transfer agents used for the synthesis of acrylic polymer is on the order of 60% by mass or greater, more preferably on the order of 75% by mass or greater, and even more preferably on the order of 90% by mass or greater. Essentially all of the sulfur-containing chain transfer agent may be a non-corrosive mercaptan. The non-corrosive mercaptan contained in the sulfur-containing chain transfer agent used in the art disclosed herein may be one species, two species or more. For instance, a chain transfer agent substantially comprising a tertiary lauryl mercaptan (may be a mixture of a plurality of structural isomers) can be used preferably.

The reason why the sulfur-containing gas emission of a PSA sheet may be efficiently decreased by the use of these non-corrosive mercaptans is inferred, for instance, as described below. An acrylic polymer synthesized in presence of a mercaptan may become one having as a residue of the mercaptan a structural moiety containing sulfur. It is thought that when this structural moiety undergoes a chemical change, it becomes a low molecular weight sulfur-containing gas and is eliminated from the acrylic polymer, which may be a factor causing a metal to corrode. However, with the non-corrosive mercaptan described above, it is thought that elimination of the sulfur-containing structural moiety from the acrylic polymer is unlikely to occur because the carbon atom adjacent to the sulfur is bonded to a bulky group, or an atom or a group having n electrons.

In one preferred mode of the art disclosed herein, as sulfur-containing chain transfer agents, those that generates essentially no sulfur-containing gas in the gas generation test described above (in other words, sulfur-containing chain transfer agents that do not contribute substantially to the amount of sulfur-containing gas generated in the test) are used. Such tertiary mercaptans (for instance, tertiary alkyl mercaptan) and aromatic mercaptans as described above are typical examples of materials that may be employed as sulfur-containing chain transfer agents that do not contribute substantially to the amount of sulfur-containing gas generated.

Note that, regarding sulfur-containing chain transfer agents other than those described above, they can also be used as long as the preferred range of sulfur-containing gas emission disclosed herein is realized. As such chain transfer agents, mercaptans with structures having at least one mercapto group bonded to a primary carbon atom (hereafter also referred to as primary mercaptan) such as n-lauryl mercaptan, 2-mercaptoethanol, mercaptoacetic acid, thioglycolic acid-2-ethylhexyl and 2,3-dimercapto-1-propanol may be given as examples. However with a mode in which only primary mercaptans are to be used as chain transfer agents, realizing the desired adhesive capability while decreasing the sulfur-containing gas emission to the preferred range disclosed herein is difficult. Consequently, when a primary mercaptan is used, it is desirable to use it in combination with the non-corrosive mercaptan as described above or a mercaptan that does not contribute to the generation of sulfur-containing gas. Alternatively, essentially no primary mercaptans may be used.

Further, chain transfer agents with structures that do not contain sulfur as a constituent atom (sulfur-free chain transfer agents) may be used in addition to sulfur-containing chain transfer agents. For instance, α-methylstyrene dimer; terpenes such as α-pinene, limonene and terpinolene; and the like, can be used.

With emulsion polymerization thus carried out, a polymerization reaction mixture is obtained in the form of an emulsion in which an acrylic polymer is dispersed in water. As the water-dispersed acrylic polymer in the art disclosed herein, this polymerization reaction mixture or the reaction mixture after a suitable work-up can be used preferably. Alternatively, a polymerization method other than the emulsion polymerization method (for instance, solution polymerization, photopolymerization, bulk polymerization, and the like) may be used to synthesize the acrylic polymer, and use a water-dispersed acrylic polymer prepared by dispersing this polymer in water.

Regarding preparation of the water-dispersed acrylic polymer, an emulsifier can be used as necessary. As emulsifiers, any of anionic, non-ionic and cationic ones can be used. In general, the use of an anionic or non-ionic emulsifier is preferred. Such emulsifiers can be used preferably, for instance, when a monomer constituent is to be emulsion-polymerized, when an acrylic polymer obtained by another method is to be dispersed in water, and the like.

As anionic emulsifiers, for instance, alkyl sulfate-type anionic emulsifiers such as sodium lauryl sulfate, ammonium lauryl sulfate and potassium lauryl sulfate; polyoxyethylene alkyl ether sulfate-type anionic emulsifiers such as sodium polyoxyethylene lauryl ether sulfate; polyoxyethylene alkyl phenyl ether sulfate-type anionic emulsifiers such as ammonium polyoxyethylene laurylphenyl ether sulfate and sodium polyoxyethylene laurylphenyl ether sulfate; sulfonate-type anionic emulsifiers such as sodium dodecylbenzene sulfonate; sulfosuccinic acid-type anionic emulsifiers such as disodium lauryl sulfosuccinate, disodium polyoxyethylene lauryl sulfosuccinate; and the like, may be cited.

In addition, as non-ionic emulsifiers, for instance, polyoxyethylene alkyl ether-type non-ionic emulsifiers such as polyoxyethylene lauryl ether; polyoxyethylene alkylphenyl ether-type non-ionic emulsifiers such as polyoxyethylene laurylphenyl ether; polyoxyethylene fatty acid ester; polyoxyethylene polyoxy propylene block polymer; and the like, may be cited. A radically polymerizing emulsifier (reactive emulsifier) with a structure comprising a radically polymerizing group (such as propenyl group) introduced into such an anionic or non-ionic emulsifier described above may also be used.

Of such emulsifiers, one species may be used alone or two or more species may be used in combination. The amount of emulsifier used suffices to be an amount used to allow an acrylic polymer to be prepared in the form of an emulsion, and is not limited in particular. For instance, selection from a range of, for instance, on the order of 0.2 to 10 parts in mass (preferably on the order of 0.5 to 5 parts in mass) based on solid content with respect to 100 parts in mass of acrylic co-polymer is adequate.

In addition to water-dispersed acrylic polymers, the PSA composition in the technique disclosed herein may further contain a tackifier resin. As tackifier resins, for instance, various tackifier resins such as rosinic, terpenic, hydrocarbon series, epoxy series, polyamide series, elastomer series, phenol series and ketone series can be used, with no particular limitation. Such tackifier resins may be used alone or in a combination of one, two species or more.

Concretely, as rosinic tackifier resins, for instance, native rosins (raw rosins) such as gum rosin, wood rosin and tall-oil rosin; modified rosins from the modification of these native rosins by hydrogenation, disproportionation, polymerization and the like (hydrogenated rosin, disproportionated rosin, polymerized rosin, other chemically modified rosins, and the like); other various rosin derivatives; and the like, may be cited. As rosin derivatives described above, for instance, rosin esters such as native rosins esterified with alcohols (that is to say, esters of rosin) and modified rosins (hydrogenated rosin, disproportionated rosin, polymerized rosin and the like) esterified with alcohols (that is to say, esters of modified rosin); unsaturated fatty acid-modified rosins comprising native rosins and modified rosins (hydrogenated rosin, disproportionated rosin, polymerized rosin and the like) modified with an unsaturated fatty acid; unsaturated fatty acid-modified rosin esters comprising rosin esters modified with an unsaturated fatty acid; rosin alcohols from the reductive treatment of a carboxyl group in native rosins, modified rosins (hydrogenated rosin, disproportionated rosin, polymerized rosin and the like), unsaturated fatty acid-modified rosins or unsaturated fatty acid-modified rosin esters; metal salts of rosins such as native rosin, modified rosin and various rosin derivatives (in particular, of rosin esters); rosin phenol resins obtained by addition of phenol to rosins (native rosin, modified rosin, various rosin derivatives and the like) with an acid catalyst and heat polymerization; and the like, may be cited.

As terpenic tackifier resins, for instance, terpenic resins such as α-pinene polymer, β-pinene polymer and dipentene polymer; modified terpenic resins in which these terpenic resins have been modified (phenol modification, aromatic modification, hydrogenation modification, hydrocarbon modification and the like); and the like, may be cited. As the modified terpene resins described above, terpene-phenolic resin, styrene-modified terpenic resin, aromatized terpenic resin, hydrogenated terpenic resin and the like may be given as examples.

As hydrocarbon series tackifier resins, for instance, resins from various hydrocarbon scries such as aliphatic hydrocarbon resin, aromatic hydrocarbon resin, aliphatic cyclic hydrocarbon resin, aliphatic/aromatic petroleum resin (styrene-olefin series co-polymers or the like), aliphatic/alicyclic petroleum resin, hydrogenated hydrocarbon resin, cumaron series resin and cumaron indene series resin may be cited. As aliphatic hydrocarbon resins, polymers of one, two or more kinds of aliphatic hydrocarbons selected fromolefins and dienes having on the order of 4 to 5 carbons and the like may be given as examples. As examples of the olefins described above, 1-butene, isobutylene, 1-pentene and the like, may be cited. As examples of the dienes described above, butadiene, 1,3-pentadiene, isoprene and the like, may be cited. As aromatic series hydrocarbon resins, polymers of vinyl group-containing aromatic series hydrocarbon having on the order of 8 to 10 carbons (styrene, vinyl toluene, α-methyl styrene, indene, methyl indene and the like), and the like, may be given as examples. As aliphatic series cyclic hydrocarbon resins, alicyclic hydrocarbon series resins polymerized after ring-forming dimerization of the so-called "petroleum C4 fraction" and "petroleum C5 faction"; polymers of cyclic diene compounds (cyclopentadiene, dicyclopentadiene, ethylidene norbornene, dipentene and the like) or hydrogen additives thereof; alicyclic hydrocarbon series resin from the hydrogenation of an aromatic ring in an aromatic series hydrocarbon resin or an aliphatic/aromatic series petroleum resin; and the like, may be given as examples.

In the art disclosed herein, tackifier resins having a softening point (softening temperature) on the order of 80°C or higher (preferably on the order of 100°C or higher) may be used preferably. According to such tackifier resins, PSA sheet of higher performance (for instance, of greater adhesive strength) may be realized. The upper limit of the softening point of the tackifier resin is not particularly set, but can be, for instance, on the order of 170°C or lower (typically on the order of 160°C or lower). Note that the softening point of the tackifier resin referred to herein is defined as the value measured according to the softening point test method (ring-and-ball method) established in JIS K 5902.

Such tackifier resins may be used preferably in the form of an emulsion in which the resin is dispersed in water. The tackifier resin emulsion described above may be prepared using an emulsifier, as necessary. As emulsifiers, one species or two species or more from similar ones to the emulsifiers that may be used for the preparation of a water-dispersed acrylic polymer can be selected suitably and used. In general, the use of an anionic emulsifier or a non-ionic emulsifier is preferred. Note that the emulsifier used for the preparation of the water-dispersed acrylic polymer and the emulsifier used for the preparation of the tackifier resin emulsion may be identical or may be differently. For instance, a mode in which an anionic emulsifier is used for the preparation of both emulsions, a mode in which a non-ionic emulsifier is used for both, a mode in which an anionic emulsifier is used on one and a non-ionic on the other, and the like, may be adopted preferably. The amount of emulsifier used is not limited in particular as long as the amount allows a tackifier resin to be prepared in the form of an emulsion, and for instance, can be selected from a range on the order of 0.2 to 10 parts in mass (preferably 0.5 to 5 parts in mass) with respect to 100 parts in mass of tackifier resin (based on solid content).

The amount of tackifier resin used is not limited in particular, and can be set suitably according to the target adhesive properties (adhesive strength or the like). For instance, the tackifier resin is preferably used at a proportion of on the order of 10 to 100 parts in mass (more preferably 15 to 80 parts in mass, and even more preferably 20 to 60 parts in mass) in solid content criteria with respect to 100 parts in mass of acrylic polymer.

In the water-dispersed PSA composition described above, a crosslinking agent may be used, as necessary. The type of crosslinking agent is not limited in particular, and can be selected suitably from among crosslinking agents that are well known and in common use (for instance, isocyanate crosslinking agents, epoxy crosslinking agents, oxazoline crosslinking agents, aziridine series crosslinking agents, melamine crosslinking agents, peroxide crosslinking agents, urea crosslinking agents, metal alkoxide crosslinking agents, metal chelate crosslinking agents, metal salt crosslinking agents, carbodiimide crosslinking agents, amine crosslinking agents and the like) and used. As crosslinking agents used here, both oil-soluble and water-soluble can be used. A crosslinking agent can be used alone or by combining two species or more. The amount of crosslinking agent used is not limited in particular, and for instance, can be selected from a range on the order of 10 parts in mass or less (for instance, on the order of 0.005 to 10 parts in mass, and preferably on the order of 0.01 to 5 parts in mass) with respect to 100 parts in mass of acrylic polymer.

The PSA composition described above may contain, as necessary, an acid or a base (aqueous ammonia or the like) used for the purpose of pH adjustment or the like. As other optional constituents that may be included in the composition, various additives that are general in the field of water based PSA composition can be given as examples, such as viscosity adjuster (thickener or the like), leveling agent, release adjuster, plasticizer, softener, filler, colorant (pigment, dye and the like), surfactant, anti-electrostatic agent, antiseptic agent, anti-aging agent, UV absorber, antioxidant and light stabilizer.

The PSA layer in the art disclosed herein can be formed suitably by conferring such a water-dispersed PSA composition as described above onto a prescribed surface and drying or curing. When conferring a PSA composition (typically coating), coaters that are in common use (for instance, gravure roll coater, reverse roll coater, kiss roll coater, dip roll coater, bar coater, knife coater, spray coater and the like) can be used. The thickness of the PSA layer is not limited in particular, and it may be for instance on the order of 2µm to 200µm (preferably on the order of 5µm to 100µm).

The PSA sheet of the present invention, which is provided with such a PSA layer may be produced by a variety of methods. For instance, a method whereby a PSA composition is directly conferred to a substrate, dried or cured to form a PSA layer on the substrate, and a release liner is layered on this PSA layer; a method whereby a PSA layer formed on a release liner is placed on a substrate, and while the PSA layer is transferred onto the substrate, the release liner is used as-is for protecting the PSA layer; and the like, can be adopted.

In the PSA sheet of the present invention, as substrate for supporting (backing) the PSA layer, for instance, plastic films such as polyolefin (polyethylene, polypropylene, ethylene-propylene co-polymer and the like) film, polyester (polyethylene terephthalate or the like) film, polyvinyl chloride resin film, vinyl acetate resin film, polyimide resin film, polyamide resinfilm, fluoro resin film and other cellophanes; papers such as Japanese paper, craft paper, glassine paper, premium paper, synthetic paper and topcoat paper; fabrics such as woven fabric and non-woven fabric from a single or blend or the like of various fibrous substances (may be any of a natural fiber, a semi-synthetic fiber or a synthetic fiber; for instance, cotton fiber, staple fiber, Manila fiber, pulp, rayon, acetate fiber, polyester fiber, polyvinyl alcohol fiber, polyamide fiber, polyolefin fiber and the like); rubber sheets comprising natural rubber, butyl rubber or the like; foam sheets comprising foams such as foam polyurethane and foam polychloroprene rubber; metal foils such as aluminum foil and copper foil; composites thereof; and the like can be used. The plastic films described previously may be of the non stretched type or may be of the stretched type (uniaxially stretched-type or biaxially stretched-type). The substrate may have a monolayer morphology, or may have a layered morphology.

As necessary, various additives may be mixed in the substrate described above, such as fillers (inorganic fillers, organic fillers and the like), anti-aging agent, antioxidant, UV absorber, anti-electrostatic agent, lubricant, plasticizer, colorant (pigment, dye and such). A surface treatment that is well known or in common use may have been carried out on the surface of the substrate
such as, for instance, corona discharge treatment, plasma treatment and coating of an undercoat. Such surface treatments may be treatments for the purpose of increasing, for instance, the substrate anchoring ability of the PSA layer. While the thickness of the substrate can be selected suitably according to the purpose, it is generally on the order of 10µm to 500µm (preferably on the order of 10µm to 200µm).

As release liners protecting or supporting the PSA layer (may be one that combine the functions of protection and support), those that are suitable can be selected from well known release liners and used, the materials and the constitution thereof not being limited in particular. For instance, a release liner having a constitution in which at least one surface of the substrate has been subjected to release treatment (typically, provided with a release ayer by a release treatment agent) can be used suitably. As substrates for constituting this type of release liner (subjects of release treatment), substrates similar to those described above as substrates constituting the PSA sheet (various plastic films, papers, fabrics, rubber sheets, foam sheets, metal foils, composites thereof and the like) can be selected suitably and used. As release treatment agents for forming the release treatment layer described above, release treatment agents that are well known or in common use (for instance, release treatment agent such as from the silicone series, fluorine series and long chain alkyl series) can be used. In addition, substrates having low adhesive properties comprising fluoropolymers (for instance, polytetrafluoroethylene, polychlorotrifluoroethylene, polyvinylfluoride, polyvinylidenefluoride, tetrafluoroethylene-hexafluoropropylene co-polymer, chlorofluoroethylene-vinylidenefluoride co-polymer and the like) or low polarity polymers (for instance, olefin series resins such as polyethylene and polypropylene, and the like) may be used as release liners on the surface of the substrate without performing a release treatment. Alternatively, such a low adhesive property substrate with a release treatment performed on the surface may be used as a release liner.

The thickness of the substrate or the release layer constituting the release liner is not limited in particular, and can be selected suitably according to the purpose or the like. The total thickness of the release liner (for a release liner with a constitution having a release layer on the substrate surface, the entire thickness including the substrate and the release layer) is, for instance, preferably on the order of 15µm or greater (typically on the order of 15µm to 500µm), and more preferably on the order of 25µm to 500µm.

In addition, if crosslinking is carried out when forming the PSA layer, crosslinking can be carried out in a prescribed production process according to the species of the crosslinking agent (for instance, the heat crosslinking type, which crosslinks by heat, the light crosslinking type, which crosslinks by UV illumination) by crosslinking methods that are well known and in common use. For instance, when a crosslinking agent of the heat crosslinking type is used, crosslinking can be carried out after coating with the water-dispersed acrylic PSA, when drying, by letting the heat-crosslinking reaction to proceed in parallel or simultaneously to this drying. Concretely, crosslinking can be carried out along with drying, by heating, according to the species of the the heat-type crosslinking agent, at a temperature at which the crosslinking reaction proceeds, or higher.

In the art disclosed herein, although the amount of solvent-insoluble fraction (crosslinked body of acrylic polymer) in the PSA constituting the PSA layer is not limited in particular, in general, it is preferably for instance on the order of 15 to 70% by mass of the entire PSA layer. The solvent-insoluble fraction described above indicates the proportion in mass of the insoluble fraction that remains when the post-crosslinking PSA has been extracted with ethyl acetate. In addition, in this case, the weight average molecular weight of the solvent-soluble fraction of the PSA (acrylic polymer obtained by extracting the PSA with tetrahydrofuran) is preferably in a range of, for instance, 100,000 to 2,000,000 (preferably on the order of 200,000 to 1,600,000) as a value converted into polystyrene in a gel permeation chromatography (GPC) method. This weight average molecular weight can be measured with a general GPC device (for instance, GPC device manufactured by TOSOH; model: HLC-8120GPC; column used: TSKgel GMH-H(S)). Note that, the proportion of the solvent-insoluble fraction and the weight average molecular weight of the solvent-soluble fraction described above can be set arbitrarily by adjusting suitably, for instance, the amount of functional group-containing monomerwith respect to the total amount of monomers, the types of the chain transfer agent and the amount thereof, the species of the crosslinking agent and the amount thereof, and the like.

The PSA sheet disclosed here is characterized by a sulfur-containing gas emission of 0.043µg SO₄²⁻/cm² or less (preferably 0.03µg SO₄²⁻/cm² or less) in a gas generation test in which the PSA sheet is heated at 85°C for one hour. From the point of view of non-corrosive properties to metal, it is desirable that the sulfur-containing gas emission from the PSA sheet is an as low a value as possible below the value described above. Therefore, as constitutive materials of the PSA sheet disclosed here and as materials used in the production process therefor, it is desirable that the use of materials which may become a source of sulfur-containing gas generation is avoided or the amount thereof used is minimized, not only for the chain transfer agent used in the synthesis of the acrylic polymer but also for the other materials. For instance, for materials other than the chain transfer agent used in the synthesis of the acrylic polymer (emulsifier, polymerization starter and the like), tackifier resin, emulsifier and other various additives that may be included in the tackifier resin emulsion, crosslinking agent, various additives that may be mixed in the water-dispersed PSA composition, substrate for PSA sheet and additives therefor, and the like, it is desirable to select those in which generation of sulfur-containing gas is unlikely to occur. This allows the non-corrosive properties of the PSA sheet to be increased all the more while using a sulfur-containing chain transfer agent to maintain a satisfactory adhesive properties. In one preferred mode, in the gas generation test described above, the fraction within the sulfur-containing gas emission from the PSA sheet contributed by materials other than the chain transfer agent (that is to say, the amount of sulfur-containing gas generated originating from materials other than the chain transfer agent) is essentially zero.

In one preferred mode of the PSA sheet disclosed here, in the gas generation test described above, the fraction within the sulfur-containing gas emission from the PSA sheet contributed by the sulfur-containing chain transfer (that is to say, the amount of sulfur-containing gas generated originating from the sulfur-containing chain transfer agent) is 0.03µg SO₄²⁻/cm² or lower (more preferably less than 0.02µg SO₄²-/cm²). According to such mode, keeping the total amount of sulfur-containing gas released from the PSA sheet to 0.043µg SO₄²⁻/cm² or lower is facilitated. For instance, this is desirable as there are broader choices of materials for the sulfur-containing chain transfer agent and the amount thereof used. In one preferred mode, the amount of sulfur-containing gas generated originating from the sulfur-containing chain transfer agent is essentially zero (typically less than 0.02µg SO₄²⁻/cm²).

The art disclosed herein may be applied to corrosion prevention of various metals that may react with a sulfur-containing gas (H₂S, SO₂ and the like) and deteriorate (formation of sulfide, sulfite, sulfate, or the like). As such metals which are targets of corrosion, transition metals such as silver, copper, titanium, chromium, iron, cobalt, nickel and zinc; metals contained in the typical elements such as aluminum, indium, tin and lead; and the like, may be cited. Due to being prone to corrosion by a sulfur-containing gas and being widely used as constitutive materials for base boards and wirings, silver and silver alloys (alloys having silver as the main constituent) may be cited as particularly desirable corrosion prevention subject metal. According to one preferred mode of the PSA sheet disclosed here, metal corrosion may be prevented, such that, when 1.0g of the PSA sheet (including the PSA layer and the substrate but not including the release liner) and a silver plate are placed in a non-contacting state inside a sealed space of 50mL in volume and kept at 85°C for one week, no alteration in the appearance indicative of corrosion (for instance, decrease or disappearance of metal sheen, coloration such as blackening) is observed on the above silver plate by visual inspection.

According to the PSA sheet disclosed here, the emission of sulfur-containing gas is highly suppressed as described above, which ensures that corrosion of metal and issues associated thereto (contact defects, decrease in quality of appearance) can be prevented or suppressed. Therefore, PSA sheet described above can be used preferably inside the housings of, for instance, televisions (liquid crystal televisions, plasma televisions, cathode-ray tube televisions and the like), computers (display, main body and the like), sound equipments, other various home appliances, OA equipment and the like, for purposes such as binding parts, surface protection, information display, sealing or filling holes and gaps (seals), and buffering vibrations and impacts. In particular, it is suitable as a PSA sheet for use in an environment where the generation of sulfur-containing gas and corrosion of metal are readily promoted due to the temperature rising inside the housing facilitated by the use of electronics (such as inside the housing of a liquid crystal television). According to the PSA sheet disclosed here, metal corrosion may be highly prevented even in such a mode of use.

The PSA sheet of the present invention may demonstrate, along with high levels of metal corrosion prevention properties, excellent adhesive properties as it is provided with a PSA layer formed from a PSA composition containing a water-dispersed acrylic polymer, with a sulfur-containing chain transfer agent being used in the synthesis of acrylic polymer described above. Consequently, said PSA sheet may be used preferably as a PSA sheet for binding parts where great adhesive properties (for instance adhesive strength) are required, inside an electronic device and other locations. The substrate of the PSA sheet of the present invention is, for instance, a sheet-form substrate (typically, non-woven fabrics and other porous substrates). With a two-sided PSA sheet, thorough penetration into the substrate to form the PSA layer is important; in addition, from the tendency of being required high adhesive properties, it is particularly significant that the molecular weight may be adjusted by using a sulfur-containing chain transfer agent. Although not to be limited in particular, the thickness of a PSA layer constituting a two-sided PSA sheet may be, for instance, on the order of 20µm to 150µm per side.

According to the present specification, a PSA composition, which is a water-dispersed PSA composition containing an acrylic polymer synthesized using a sulfur-containing chain transfer agent, providing a PSA (typically, the PSA is formed by drying or curing) for which the sulfur-containing gas emission is 2.7µg SO₄²⁻/g or lower (more preferably 1.9µg SO₄²⁻/g or lower, for instance less than 1.2µg SO₄²⁻/g) in the gas generation test described above, is further provided. Such a PSA composition may be used preferably, for instance, to produce any of the PSA sheets disclosed here. In addition, the PSA composition, since it may form a PSA with a low sulfur gas emission as described above, is desirable in applications where a PSA serving functions such as sealing, filling and buffering inside the housing of an electronic device and other locations is formed (not limited to sheet-form, and may have a mass-shape and other various shapes).

According to the art disclosed herein, a PSA sheet for which the adhesive strength against a stainless plate (SUS: BA304) (may be understood by the adhesiveness measurement described below) is on the order of 1.5N/20mm or greater (typically 1.5N to 20N/20mm or greater) may be provided. According to a preferred mode, a two-sided substrated sheet for which the adhesive strength described above is on the order of 3N/20mm or greater (more preferably on the order of 4N/20mm or greater, for instance 5N/20mm or greater) may be provided. In addition, according to the art disclosed herein, a a two-sided substrated PSA sheet may be provided, which demonstrates a cohesive strength (may be understood by the cohesive strength measurement described below) to an extent that, when bonded to a phenol resin ! plate, the shift distance after one hour at 40°C is less than 20 mm. According to a preferred mode a two-sided substrated PSA sheet may be provided demonstrating a cohesive strength to an extent that the shift distance described above is less than 15 mm (more preferably less than 10 mm, for instance less than 1 mm). A PSA sheet that satisfies both the adhesiveness and the cohesive strength described above is desirable.

### EXAMPLES

Hereafter, a number of examples according to the present invention will be described; however, the present invention is not intended to be limited to those indicated in examples. Note that in the following description, mass is the criteria for "part" and "%" unless expressly indicated otherwise.

### <Example 1>

Into a reaction vessel equipped with a condenser, a nitrogen inlet tube, a thermometer and a stirrer, 40 parts of ion-exchanged water was introduced, and the reaction vessel was purged with nitrogen by stirring at 60°C for one hour or longer under nitrogen flow. To this reaction vessel, 0.1 parts of 2,2'-azobis[*N*-(2-carboxyethyl)-2-methylpropionamidine] hydrate (polymerization starter) was added. While maintaining the system at 60 °C, a monomer emulsion was added therein dropwise gradually over three hours to proceed with the emulsion polymerization reaction. As for the monomer emulsion, 90 parts of butylacrylate, 10 parts of 2-ethylhexylacrylate, 4 parts of acrylic acid, 0.02 parts of tertiary butyl mercaptan, 0.07 parts of 3-methacryloxy propyltrimethoxysilane (Shin-Etsu Chemical Co., Ltd. product; product name: KBM-503) and 2 parts of polyoxyethylene sodium lauryl sulfate (emulsifier) added to 30 parts of ion exchanged water and emulsified was used. After the dropwise addition of the monomer emulsion was finished, the system was further maintained at 60°C for three hours, and 0.075 parts of hydrogen peroxide water and 0.15 parts of ascorbic acid were added. In this way, a water-dispersed acrylic polymer was synthesized. The polymerization reaction mixture obtained above was cooled to room temperature and then the pH was adjusted to 7 by the addition of 10% aqueous ammonia to obtain the water-dispersed acrylic PSA composition according to the present example.

The PSA composition was coated over a release liner having a release layer treated with a silicone release agent (product name: SLB-80WD (V2); manufactured by Sumika-Kakoushi Co., Ltd.) dried at 100°C for two minutes to form a PSA layer having a thickness of approximately 60µm. Two sheets of this PSA-layered release liners were prepared, these PSA layers were respectively placed on each side of a non-woven fabric substrate (product name: SP genshi-14; manufactured by Daifuku Paper MGF Co., Ltd.; grammage: 14g/m²) to produce a two-sided PSA sheet. Each adhesive side of this two-sided PSA sheet is protected as-is by the release liner used in producing the PSA sheet.

### <Example 2>

In the present example, 0.05 parts of tertiary lauryl mercaptan (manufactured by Tokyo Chemical Industry Co., Ltd.) was used instead of the tertiary butyl mercaptan used in Example 1. In a similar manner to Example 1 regarding the other points, a water-dispersed acrylic PSA composition was obtained, and this composition was used to produce a two-sided PSA sheet in a similar manner to Example 1.

### <Example 3>

In the present example, 0.03 parts of phenyl mercaptan was used instead of the tertiary butyl mercaptan used in Example 1. In a similar manner to Example I regarding the other points, a water-dispersed acrylic PSA composition was obtained, and this composition was used to produce a two-sided PSA sheet in a similar manner to Example 1.

### <Example 4> (Comparative example)

In the present example, 0.05 parts of n-lauryl mercaptan was used instead of the tertiary butyl mercaptan used in Example 1. In a similar manner to Example I regarding the other points, a water-dispersed acrylic PSA composition was obtained, and this composition was used to produce a two-sided PSA sheet in a similar manner to Example 1.

For each PSA sheet obtained above, the following measurement or evaluation was carried out. The results thereof are shown in Table 1. This table shows together the species of the chain transfer agent used during emulsion polymerization in each example.

### <Adhesiveness measurement>

The release liner covering the adhesive surface on one side of the two-sided PSA sheet was peeled off and a 25µm-thick polyethylene terephthalate (PET) film was adhered for backing. This backed PSA sheet cut into a size of 20mm in width and 100mm in length served as a measurement sample. The release liner was peeled off from the adhesive surface on the other side of the sample, which was pressure-bonded to a stainless (SUS: BA304) plate with a 2kg roller traveling back and forth once. This was stored at 23°C for 30 minutes, then, 180°-peel strength (adhesive strength) was measured using a tensile tester, in a measurement environment of 23°C temperature and 50% RH, at a pull speed of 300 mm/minute, in accordance with JIS Z 0237.

### <Cohesive strength (holding strength) measurement>

The release liner covering the adhesive surface on one side of the two-sided PSA sheet was peeled off and a 25µm-thick PET film was adhered for backing. This backed PSA sheet was cut to 10mm width to produce a sample strip. The release liner was peeled off from the other side of the sample strip, and the sample strip was bonded to a phenol resin plate serving as an adherend, in a 10mm-wide, 20mm-long adhesive surface area. This was left in a 40°C environment for 30 minutes, then, the phenol resin plate was hung and a 500g load was added to the free end of the sample strip. In accordance with JIS Z 0237, the shift distance (mm) was measured after the sample strip was left in a state with the load added in a 40°C environment for one hour.

### <Measurement of sulfur-containing gas emission>

Approximately 0.1g of each PSA sheet of which the release liner was peeled off from each adhesive surface was placed on a furnace sample boat and heated at 85°C for one hour using a furnace (automatic sample furnace manufactured by Dia Instruments Co., Ltd., model AQF-100). The gas generated from the PSA sheet in so doing was passed through 10mL of an absorption solution. This absorption solution comprised 30ppm hydrogen peroxide in pure water, allowing the sulfur-containing gas (H₂S, SO₂ and the like) that may be included in the generated gas described above to be converted into SO₄²⁻ and collected. The absorption solution after passage of the generated gas was added with pure water to adjust the volume to 20mL, and the amount of SO₄²⁻ generated per 1g of PSA sheet was determined by carrying out a quantitative analysis of SO₄²⁻ using an ion chromatograph (manufactured by Dionex; product name: DX-320). Note that similar operations were carried out with the sample boat described above in an empty state, which served as blank. The obtained results were converted into amounts of SO₄²⁻ generated per surface area of each PSA sheet and amounts of SO₄²⁻ generated per 1g of PSA. These results are shown in Table 1. Note that in the conversion described above used the facts that the mass per 1cm² of PSA sheet according to each example was 0.017g, and that the mass of PSA contained in 1cm² of each PSA sheet was 0.0156g.

### [Automatic sample furnace operating conditions]

Temperature: Inlet = 85°C; Outlet = 85°C
Gas flow rate: O₂ = 400mL/minute; Ar (water sending unit: 0 graduation) = 150mL/minute

### [Conditions for measurements by (anionic) ion chromatograph]

Separation column: IonPac AS18 (4mm × 250mm)
Guard column: IonPac AG18 (4mm × 50mm)
Removal system: ASRS-ULTRA (external mode, 75mA)
Detector: electric conductivity detector
Eluents: 13mM KOH (0 to 20 minutes)
   30mM KOH (20 to 30 minutes)
   (eluent generator EG40 used)
Eluent flow rate: 1.0mL/minute
Sample injection amount: 250µL

### <Metal corrosivity test>

Approximately 1.0g of each PSA sheet (comprising a non-woven fabric substrate and the PSA layers provided on each side thereof) of which the release liner was peeled off from each adhesive surface and a polished silver plate (silver purity > 99.95%; size: 1 mm × 10mm × 10mm) were placed in a 50mL screw-capped tube so as not to come into direct contact with each other, and the tube was sealed and stored at 85°C for one week. The silver plate after the test was compared to an unused silver plate (prior to the test) and whether or not corrosion occurred (determined by the disappearance of metal sheen, alteration of external appearance such as coloration) was determined visually to evaluate metal corrosivity. The results are shown in Table 1, where metal corrosivity was "Present" if corrosion was observed, and metal corrosivity was "Absent" if no corrosion was observed.

**Table 1**

| | Example 1 | Example 2 | Example 3 | Example 4 (Comparative Example) |
|---|---|---|---|---|
| Chain transfer agent | t-BuSH | t-LSH | PhSH | LSH |
| Adhesive strength to SUS [N/20mm] | 6.5 | 5.8 | 5.3 | 6.0 |
| Cohesive strength at 40°C, 500g × one hour [mm] | 0.1 | 0.2 | 0.1 | 0.2 |
| Amount of SO₄²⁻ generated per 1g of PSA sheet [µg/g] | <1.1 | <1.1 | < 1.1 | 2.7 |
| Amount of SO₄²⁻ generated per 1 cm² of PSA sheet [µg/cm²] | <0.02 | <0.02 | <0.02 | 0.045 |
| Amount of SO₄²⁻ generated per 1 g of PSA [µg/g] | <1.2 | <1.2 | <1.2 | 2.9 |
| Metal corrosivity | Absent | Absent | Absent | Present |

| | | | | |
|---|---|---|---|---|
| t-BuSH : tertiary butyl mercaptan t-LSH : tertiary lauryl mercaptan PhSH : phenyl mercaptan LSH : n-lauryl mercaptan | | | | |

As shown in the above table, the PSA sheets according to Examples 1 to 3, which used a tertiary alkyl mercaptan or an aromatic mercaptan as the chain transfer agent, all demonstrated satisfactory adhesive strength and cohesive strength, and the amount of sulfur-containing gas generated was 0.043µg SO₄²⁻/cm² or lower (more concretely less than 0.02µg SO₄²⁻/cm²). Then, these PSA sheets according to Example 1 to 3 were all verified to not corrode silver in the metal corrosivity test described above. Meanwhile, with Example 4 (comparative example), which uses n-lauryl mercaptan (primary alkyl mercaptan) as the chain transfer agent, although adhesive strength and cohesive strength are obtained to similar extents to Examples 1 to 3, the amount of sulfur-containing gas generated is abundant, and it was verified to corrode silver in the metal corrosivity test described above. That is to say, according to Examples 1 to 3, the remarkable effect of solving the problem of metal corrosivity while maintaining adhesive capabilities to similar extents to Example 4 was realized.

## Claims

1. A pressure-sensitive adhesive sheet comprising a pressure-sensitive adhesive layer formed from a water-dispersed pressure-sensitive adhesive composition,
wherein said pressure-sensitive adhesive composition comprises a water-dispersed acrylic polymer synthesized using a chain transfer agent containing sulfur as a constituent atom, said chain transfer agent having as a main component a mercaptan having at most one hydrogen atom bonded to the carbon atom to which the mercapto group is bonded or a mercaptan in which the carbon atom has a resonance structure, and wherein the main component is a constituent being present in a concentration of at least 50% by mass in the sulfur containing chain transfer agent,
wherein the pressure-sensitive adhesive sheet is constituted as a two-sided pressure-sensitive adhesive sheet provided with said pressure-sensitive adhesive layer on each side of a substrate, and
in a gas generation test whereby said pressure-sensitive adhesive sheet is heated at 85°C for one hour, the emission of gas containing sulfur as a constituent atom is 0.043µg or less per 1cm² surface area of said sheet when converted to SO₄²⁻.

2. The pressure-sensitive adhesive sheet according to Claim 1, wherein said chain transfer agent comprises as a main component a mercaptan with a structure having no hydrogen atom on a carbon atom bonded to a mercapto group.

3. The pressure-sensitive adhesive sheet according to Claim 2, wherein said mercaptan is one, two or more species selected from the group consisting of tertiary mercaptans and aromatic mercaptans.

4. Use of the pressure-sensitive adhesive sheet according to any one of Claims 1 to 3 inside an electronic device.

## Patentansprüche

1. Haftklebefolie umfassend eine Haftklebstoffschicht, gebildet aus einer wasserdispergierten Haftklebstoffzusammensetzung,
wobei die Haftklebstoffzusammensetzung ein wasserdispergiertes Acrylpolymer umfasst, das unter Verwendung eines Kettenübertragungsreagenzes synthetisiert ist, das Schwefel als konstituierendes Atom enthält, wobei das Kettenübertragungsreagenz als eine Hauptkomponente ein Mercaptan aufweist, bei dem höchstens ein Wasserstoffatom an das Kohlenstoffatom gebunden ist, an das die Mercaptogruppe gebunden ist, oder ein Mercaptan aufweist, in welchem das Kohlenstoffatom eine Resonanzstruktur aufweist, und wobei die Hauptkomponente ein Konstituent ist, der in einer Konzentration von wenigstens 50 Massenprozent in dem schwefelhaltigen Kettenübertragungsreagenz vorhanden ist,
wobei die Haftklebefolie als eine zweiseitige Haftklebefolie ausgebildet ist, die auf jeder Seite eines Substrats mit der Haftklebstoffschicht versehen ist, und
in einem Gaserzeugungstest, bei dem die Haftklebefolie eine Stunde auf 85 °C erwärmt wird, die Emission von Gas, das Schwefel als konstituierendes Atom enthält, 0,043 µg oder weniger pro 1 cm² Oberfläche der Folie beträgt, wenn es in SO₄²⁻ umgewandelt ist.

2. Haftklebefolie nach Anspruch 1, wobei das Kettenübertragungsreagenz als eine Hauptkomponente ein Mercaptan mit einer Struktur umfasst, die kein Wasserstoffatom an einem Kohlenstoffatom aufweist, das an eine Mercaptogruppe gebunden ist.

3. Haftklebefolie nach Anspruch 2, wobei es sich bei dem Mercaptan um eine, zwei oder mehr Spezies, ausgewählt aus der Gruppe bestehend aus tertiären Mercaptanen und aromatischen Mercaptanen, handelt.

4. Verwendung der Haftklebefolie nach einem der Ansprüche 1 bis 3 im Inneren einer elektronischen Vorrichtung.

## Revendications

1. Feuille autoadhésive comprenant une couche adhésive sensible à la pression formée d'une composition adhésive sensible à la pression dispersée dans de l'eau,
dans laquelle ladite composition sensible à la pression comprend un polymère acrylique dispersé dans de l'eau synthétisé à l'aide d'un agent de transfert de chaîne contenant du soufre en tant qu'atome constitutif, ledit agent de transfert de chaîne ayant comme composant principal un mercaptan ayant au plus un atome d'hydrogène lié à l'atome de carbone auquel le groupe mercapto est lié ou un mercaptan dans lequel l'atome de carbone a une structure en résonance, et où le composant principal est un constituant qui est présent à une concentration d'au moins 50 % en masse dans l'agent de transfert de chaîne contenant du soufre,
dans laquelle la feuille autoadhésive est constituée comme une feuille autoadhésive double face dotée de ladite couche adhésive sensible à la pression sur chaque face d'un substrat, et
dans un test de génération de gaz où ladite feuille autoadhésive est chauffée à 85 °C pendant une heure, l'émission de gaz contenant du soufre en tant qu'atome constitutif est de 0,043 µg ou moins par 1 cm² d'aire superficielle de ladite feuille après conversion en SO₄²-.

2. Feuille autoadhésive selon la revendication 1, dans laquelle ledit agent de transfert de chaîne comprend comme composant principal un mercaptan avec une structure n'ayant aucun atome d'hydrogène sur un atome de carbone lié à un groupe mercapto.

3. Feuille autoadhésive selon la revendication 2, dans laquelle ledit mercaptan consiste en un, deux ou plusieurs espèces choisies dans le groupe constitué des mercaptans tertiaires et des mercaptans aromatiques.

4. Utilisation de la feuille autoadhésive selon l'une quelconque des revendications 1 à 3 à l'intérieur d'un dispositif électronique.
